(19) Europäisches Patentamt / European Patent Office / Office européen des brevets

(11) **EP 4 475 199 A1**

(12) **EUROPEAN PATENT APPLICATION**

(43) Date of publication:
**11.12.2024 Bulletin 2024/50**

(21) Application number: **24180080.4**

(22) Date of filing: **05.06.2024**

(51) International Patent Classification (IPC):
**H01L 33/44** (2010.01)   **H01L 33/46** (2010.01)

(52) Cooperative Patent Classification (CPC):
**H01L 33/44;** H01L 33/46

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **06.06.2023 US 202363506567 P**
**30.05.2024 US 202418678588**

(71) Applicant: **Viavi Solutions Inc.**
**Chandler, AZ 85286 (US)**

(72) Inventor: **HOUCK, William D**
**Santa Rosa, CA 95404 (US)**

(74) Representative: **Murgitroyd & Company**
**165-169 Scotland Street**
**Glasgow G5 8PL (GB)**

(54) **OPTICAL ELEMENT OF AN EMITTER**

(57)   An emitter includes a light emission region configured to emit light associated with a first optical spectrum, a light emission surface, and an optical element disposed on the light emission surface. A first surface of the optical element, which contacts the light emission surface, is configured to reflect light associated with the first optical spectrum. A second surface of the optical element, opposite the first surface of the optical element, is configured to absorb light associated with a second optical spectrum. At least one aperture is formed in the optical element.

FIG. 1A

**Description**

CROSS-REFERENCE TO RELATED APPLICATION

This Patent Application claims priority to U.S. Patent Application No. 63/506,567, filed on June 6, 2023, and entitled "OPTICAL ELEMENT WITH REFLECTIVE AND ABSORBENT COATING." The disclosure of the prior Application is considered part of and is incorporated by reference into this Patent Application.

BACKGROUND

A light-emitting diode (LED) is a semiconductor device that emits light when an electric current is applied to the LED. An LED includes a light emission region in which light is produced and a light emission surface through which the light emits from the LED.

SUMMARY

In some implementations, an emitter includes a light emission region configured to emit light associated with a first optical spectrum; a light emission surface; and an optical element disposed on the light emission surface, wherein: a first surface of the optical element, which contacts the light emission surface, is configured to reflect light associated with the first optical spectrum, a second surface of the optical element, opposite the first surface of the optical element, is configured to absorb light associated with a second optical spectrum, and at least one aperture is formed in the optical element.

In some implementations, an optical device includes a plurality of emitters; a plurality of optical elements respectively disposed on light emission surfaces of the plurality of emitters, wherein for each optical element: a first surface of the optical element, that is disposed on a light emission surface of an emitter, is configured to reflect light associated with a first optical spectrum; a second surface of the optical element is configured to absorb light associated with a second optical spectrum; and at least one aperture is formed in the optical element.

In some implementations, a wafer includes a plurality of emitters; a plurality of optical elements respectively disposed on the plurality of emitters, wherein for each optical element: a first surface of the optical element, that is disposed on a surface of an emitter, is configured to reflect light associated with a first optical spectrum; a second surface of the optical element is configured to absorb light associated with a second optical spectrum; and at least one aperture is formed in the optical element.

BRIEF DESCRIPTION OF THE DRAWINGS

Figs. 1A-1B are diagrams of an example implementation associated with an optical element of an emitter.
Fig. 2 is a diagram of an example implementation associated with an optical element of an emitter.
Fig. 3 is a diagram of an example implementation associated with an optical element of an emitter.
Figs. 4A-4D are diagrams of example plots associated with an optical element of an emitter.

DETAILED DESCRIPTION

The following detailed description of example implementations refers to the accompanying drawings. The same reference numbers in different drawings may identify the same or similar elements.

An emitter, such as an LED, may emit light associated with an optical spectrum. For example, the emitter may emit red light, green light, or blue light. In some cases, a polymer with an aperture can be formed over a light emission surface of the emitter to control an amount and direction of light that emits from the emitter (e.g., via the aperture). For example, the polymer can be configured to absorb light generated by the emitter that propagates to the polymer, and the aperture can be shaped such that only light with a desired propagation path and angle propagates through the aperture to emit from the emitter. In some cases, such as when the emitter is included in a display screen with many other emitters, a polymer and aperture may be formed on each emitter to individually control light emission by the emitters and thereby provide a desired overall light emission performance of the display screen.

However, a junction temperature of an emitter (e.g., when emitting is light) is high, such as greater than or equal to 85 degrees Celsius (°C). Such a high junction temperature can cause, over an operable life of the emitter, the polymer to degrade and deform. For example, the polymer may degrade such that the polymer allows some light that is generated by the emitter and that propagates to the polymer to transmit through the polymer, or the polymer may deform such that the polymer does not fully cover the light emission surface of the emitter or such that a size and shape of the aperture changes. This can cause the emitter to cease providing a desired light emission performance.

Some implementations described herein include an emitter. The emitter includes a light emission region configured to emit light associated with a first optical spectrum and a light emission surface. An optical element is disposed on the light emission surface, wherein a first surface of the optical element (e.g., that contacts the light emission surface) is configured to reflect light associated with the first optical spectrum, a second surface of the optical element (e.g., that is opposite the first surface of the optical element) is configured to absorb light associated with a second optical spectrum, and at least one aperture is formed in the optical element.

Accordingly, the first surface reflects light that is produced by the light emission region of the emitter and that propagates to a region of the light emission surface that is covered by the first surface of the optical element (e.g., a region that is not associated with the aperture), which allows the light (or at least some of the light) to propagate back to the light emission region of the emitter. Additionally, other light produced by the light emission region of the emitter propagates to the at least one aperture (e.g., because the other light has a desired propagation direction and angle) and therefore emits from the emitter to provide a desired light emission performance. Notably, the light reflected by the first surface of the optical element to the light emission region of the emitter is able to participate in photon recycling (e.g., within the light emission region) to enable further light emission by the light emission region and to improve a quantum efficiency of the emitter. This results in higher brightness and improved energy efficiency of the emitter (e.g., as compared to an emitter that does not include an optical element as described herein).

Additionally, the second surface of the optical element absorbs light associated with a second optical spectrum, which is at least partially co-extensive with the first optical spectrum. For example, the second optical spectrum may include visible light (e.g., a wavelength range from 380 to 780 nm) such that the second surface of the optical element appears (e.g., to a human observer or to a device configured to sense visible light) to have no reflection (e.g., to appear black). Accordingly, in some scenarios, such as when multiple emitters are included in a display screen of an optical device, the display screen may appear to have a consistent appearance (e.g., a black appearance), such as when the plurality of emitters are not operating and emitting light.

Notably, in some implementations, the optical element, to provide the reflective characteristics of the first surface of the optical element and the absorptive characteristics of the second surface of the optical element, comprises at least one layer that includes at least a metal material and at least one other layer that includes at least a dielectric material (e.g., arranged in a particular stack order). Because of the composition of the layers (e.g., because the layers do not comprise a polymer), the optical element is able to withstand high junction temperatures of the emitter (e.g., junction temperatures that are greater than or equal to 85 degrees Celsius). Accordingly, the optical element does not degrade, deform, or otherwise cease to perform as intended over an operable life of the emitter. This enables the emitter to provide a desired light emission performance over the operable life of the emitter (and therefore an improved light emission performance as compared to an emitter that uses a polymer instead of the optical element described herein).

In some general embodiments, the optical element may optionally comprise a plurality of layers, wherein: at least one layer, of the plurality of layers, includes at least a metal material; and at least one other layer, of the plurality of layers, includes at least a dielectric material.

Optionally, the second optical spectrum is at least partially co-extensive with the first optical spectrum.

Optionally, the first surface of the optical element is configured to reflect at least a threshold percentage of light associated with the first optical spectrum, wherein the threshold percentage is greater than or equal to at least one of: 50%, 75%, 85%, 90%, 95%, 99%, or 99.5%.

Optionally, the first surface of the optical element is configured to reflect at least the threshold percentage of light associated with the first optical spectrum when the light impinges on the first surface at an incidence angle that is less than an incidence angle threshold, wherein the incidence angle threshold is less than or equal to at least one of: 5 degrees, 10 degrees, 15 degrees, 25 degrees, 35 degrees, 50 degrees, 60 degrees, or 75 degrees.

Optionally, the second surface of the optical element is configured to absorb at least a threshold percentage of light associated with the second optical spectrum, wherein the threshold percentage greater than or equal to at least one of: 50%, 75%, 85%, 90%, 95%, 99%, or 99.5%.

Optionally, the second surface of the optical element is configured to absorb at least the threshold percentage of light associated with the second optical spectrum when the light impinges on the second surface at an incidence angle that is less than an incidence angle threshold, wherein the incidence angle threshold is less than or equal to at least one of: 5 degrees, 10 degrees, 15 degrees, 25 degrees, 35 degrees, 50 degrees, 60 degrees, or 75 degrees.

Optionally, the first optical spectrum has a spectral width greater than or equal to at least one of: 25 nanometers (nm), 30 nm, 35 nm, or 40 nm.

Optionally, the optical element is an optical thin film.

Optionally, the at least one aperture has one of a: a round shape, or a polygonal shape.

Optionally, the optical element has a maximum junction temperature within a temperature range from 85 degrees Celsius to 150 degrees Celsius.

In another aspect, the present invention provides an optical device, comprising:

> a plurality of emitters;
> a plurality of optical elements respectively disposed on light emission surfaces of the plurality of emitters, wherein for each optical element:
>
>> a first surface of the optical element, that is disposed on a light emission surface of an emitter, is configured to reflect light associated with a first optical spectrum;
>> a second surface of the optical element is configured to absorb light associated with a second optical spectrum; and

at least one aperture is formed in the optical element.

Optionally, each optical element in the optical device comprises a plurality of layers, wherein: at least one layer, of the plurality of layers, includes at least a metal material; and at least one other layer, of the plurality of layers, includes at least a dielectric material.

Optionally, the first optical spectrum in the optical device has a spectral width greater than or equal to at least one of: 25 nanometers (nm), 30 nm, 35 nm, or 40 nm.

Optionally, the second optical spectrum in the optical device includes a wavelength range from 380 to 780 nanometers.

In another aspect, the present invention provides a wafer, comprising:

a plurality of emitters;

a plurality of optical elements respectively disposed on the plurality of emitters, wherein for each optical element:

a first surface of the optical element, that is disposed on a surface of an emitter, is configured to reflect light associated with a first optical spectrum;

a second surface of the optical element is configured to absorb light associated with a second optical spectrum; and

at least one aperture is formed in the optical element.

Optionally, each optical element in the wafer comprises a plurality of layers, wherein: at least one layer, of the plurality of layers, includes at least a metal material; and at least one other layer, of the plurality of layers, includes at least a dielectric material.

Optionally, each emitter in the wafer is configured to emit light associated with the first optical spectrum.

Optionally, the first optical spectrum in the wafer has a spectral width greater than or equal to at least one of: 25 nanometers (nm), 30 nm, 35 nm, or 40 nm.

Optionally, each emitter of the wafer is a light-emitting diode (LED).

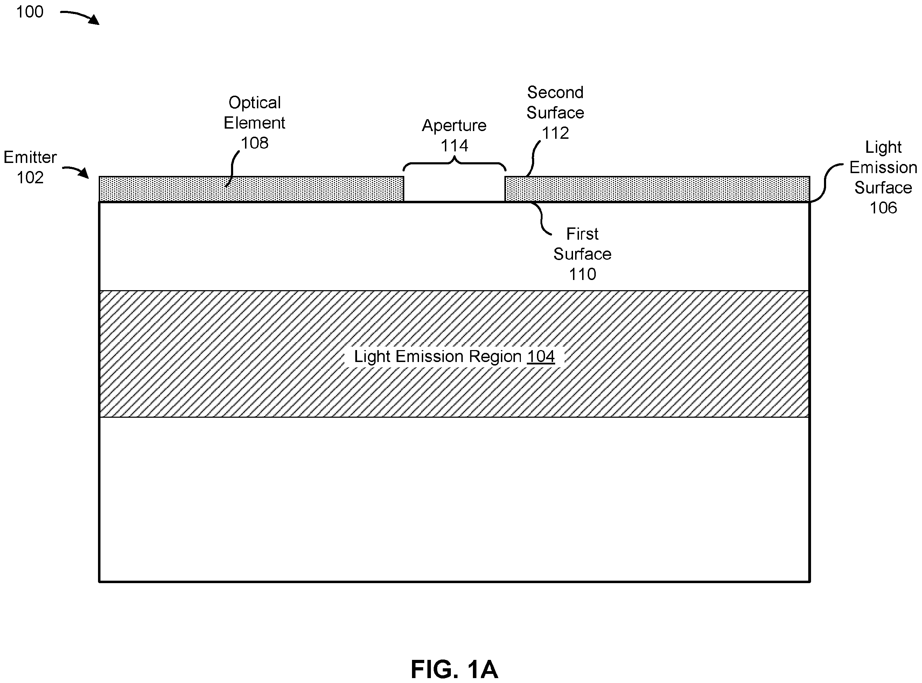

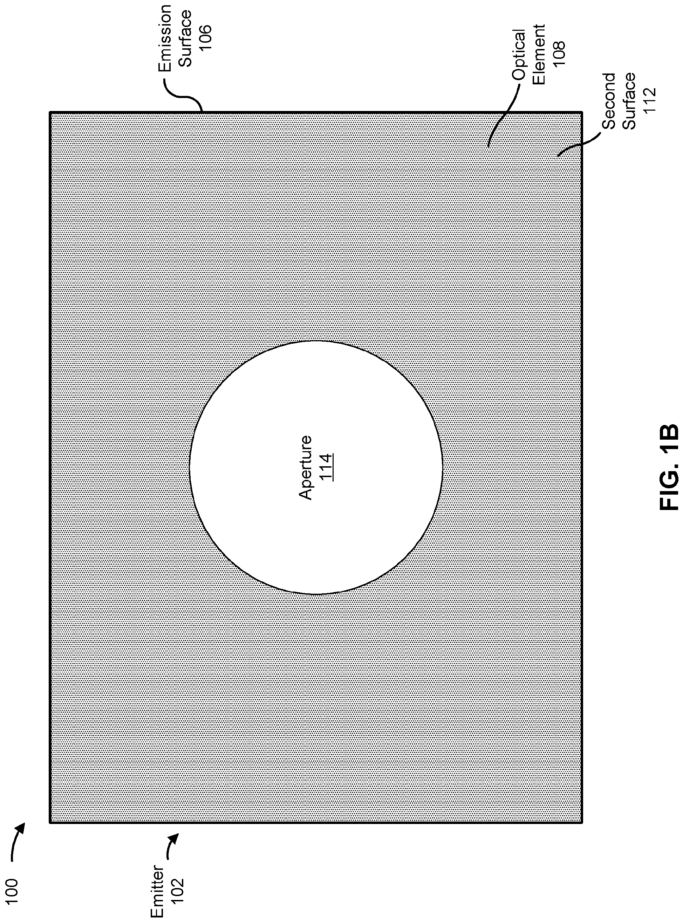

Figs. 1A-1B are diagrams of an example implementation 100 associated with an optical element of an emitter. As shown in Figs. 1A-1B, the example implementation 100 includes an emitter 102. The emitter 102 includes a light emission region 104 and a light emission surface 106. As further shown in Figs. 1A-1B, the emitter 102 includes an optical element 108 with a first surface 110 and a second surface 112, and, in some implementations, at least one aperture 114 (shown in Figs. 1A-1B as a single aperture 114) may be formed in the optical element 108. Fig. 1A shows an example side, cross-section view of the emitter 102. Fig. 1B shows an example top-down view of the emitter 102.

The emitter 102 may be configured to emit light associated with a first optical spectrum. For example, the emitter 102 may be configured to emit light, centered at a particular wavelength within the first optical spectrum, and with a wavelength that is greater than or equal to a minimum wavelength of the first optical spectrum and that is less than or equal to a maximum wavelength of the first optical spectrum. The first optical spectrum may include one or more subranges of light associated with ultraviolet light through infrared light, such as one or more portions of ultraviolet light (e.g., one or more portions of light associated with wavelengths from 200 nm to 379 nm), one or more portions of visible light (e.g., one or more portions of light associated with wavelengths from 380 nm to 780 nm), and/or one or more portions of infrared light (e.g., one or more portions of light associated with wavelengths from 781 nm to 5000 nm). In some implementations, the first optical spectrum may have a spectral width greater than or equal to a spectral width threshold. The spectral width threshold may be, for example, 25 nm, 30 nm, 35 nm, or 40 nm, for example (e.g., a spectral width associated with light emitted by an LED).

In some implementations, the emitter 102 may be an LED (e.g., an inorganic LED, an organic LED, a microLED, or another type of LED). Accordingly, as shown in Fig. 1A, the emitter 102 may include the light emission region 104. The light emission region 104 is a region where electrons and electron holes combine to produce light (e.g., associated with the first optical spectrum) that is to emit from the emitter 102. Accordingly, the emitter 102 is configured to allow light (e.g., that is produced in the light emission region 104) to propagate to the light emission surface 106 to allow the light to emit from the emitter 102 (e.g., via the at least one aperture 114, as further described herein) or to allow the light to be reflected back into the emitter 102 (e.g., by the first surface 110 of the optical element 108, as further described herein).

The emitter 102 may operate at one or more temperatures (e.g., to produce light in the light emission region 104), and may have a maximum junction temperature (e.g., a highest junction temperature at which the emitter 102 is able to reliably operate). The maximum junction temperature may be, for example, within a temperature range from 85° C to a maximum temperature threshold, where the maximum temperature threshold is greater than 85° C and less than or equal to at least one of 100° C, 105° C, 110° C, 115° C, 120° C, 125° C, 130° C, 135° C, 140° C, 145° C, or 150° C.

As shown in Fig. 1A, the optical element 108 may disposed on (e.g. disposed directly on) the light emission surface 106 of the emitter 102. For example, the first surface 110 of the optical element 108 may contact the light emission surface 106. The first surface 110 of the optical element 108 may be configured to reflect light associated with the first optical spectrum (e.g., light with a wavelength that is greater than or equal to the minimum wavelength of the first optical spectrum and that is less than or equal to the maximum wavelength of the first optical spectrum). For example, the first surface 110 may be configured to reflect at least a threshold percentage of light associated with the first optical spectrum, where the threshold percentage is greater than or equal to at least one of 50%, 75%, 85%, 90%, 95%, 99%, or 99.5%, among other examples. Additionally, the first surface 110 may be configured to reflect at least the threshold percentage of light associated with the first optical spectrum when the light impinges on the first surface 110 at an incidence angle (e.g., an angle with respect to a normal of the first surface 110) that is less than an incidence angle threshold, where the incidence angle threshold is less than or equal to at least one 5 degrees, 10 degrees, 15 degrees, 25 degrees, 35 degrees, 50 degrees, 60 degrees, or 75 degrees. The incidence angle threshold may be configured to encompass an emission angle spread of light produced by the emitter 102.

Accordingly, the first surface 110 may reflect light that is produced by the light emission region 104 and that propagates to a region of the light emission surface 106 that is covered by the first surface 110 of the optical element 108 (e.g., a region that is not associated with the aperture 114), which allows the light (or at least some of the light) to propagate back to the light emission region 104 of the emitter 102. This therefore allows the light to participate in photon recycling to enable further light emission by the light emission region 104 and improve an efficiency of the emitter 102.

The second surface 112 of the optical element 108 may be an external surface of the optical element 108 (e.g., that does not contact any other component of the emitter 102). For example, as shown in Fig. 1A, the second surface 112 of the optical element 108 may be opposite the first surface 110 of the optical element 108, such as to form a top surface of the emitter 102. The second surface 112 of the optical element 108 may be configured to absorb light associated with a second optical spectrum (e.g., light with a wavelength that is greater than or equal to a minimum wavelength of the second optical spectrum and that is less than or equal to a maximum wavelength of the second optical spectrum). For example, the second surface 112 may be configured to absorb at least a threshold percentage of light associated with the second optical spectrum, where the threshold percentage is greater than or equal to at least one of 50%, 75%, 85%, 90%, 95%, 99%, or 99.5%, among other examples. Additionally, the second surface 112 may be configured to absorb at least the threshold percentage of light associated with the second optical spectrum when the light impinges on the second surface 112 at an incidence angle (e.g., an angle with respect to a normal of the second surface 112) that is less than an incidence angle threshold, where the incidence angle threshold is less than or equal to at least one of 5 degrees, 10 degrees, 15 degrees, 25 degrees, 35 degrees, 50 degrees, 60 degrees, or 75 degrees.

The second optical spectrum may include one or more subranges of light associated with ultraviolet light through infrared light, such as one or more portions of ultraviolet light, one or more portions of visible light, and/or one or more portions of infrared light. In some implementations, the second optical spectrum is at least partially co-extensive with the first optical spectrum (e.g., at least a portion of the second optical spectrum overlaps with the first optical spectrum). In some implementations, the second optical spectrum includes visible light (e.g., a wavelength range from 380 to 780 nm) such that the second surface 112 of the optical element 108 appears (e.g., to a human observer or to a device configured to sense visible light) to have no reflection (e.g., to appear black).

The optical element 108 may comprise a plurality of layers, such as one or more reflective layers, one or more absorbing layers, and/or one or more other layers (e.g., arranged in a particular stack order). In some implementations, at least one layer, of the plurality of layers, may include at least a metal material. The metal material may include, for example, aluminum, tantalum, niobium, titanium, nickel, chromium, silicon, gold, and alloys thereof (e.g., an alloy of two or more metals, an alloy of at least one listed metal and at least one other metal, among other examples), such as tantalum-niobium alloys (e.g., $Ta_{80}Nb_{20}$, $Ta_{60}Nb_{40}$, $Ta_{40}Nb_{60}$, and/or $Ta_{20}Nb_{80}$). At least one other layer, of the plurality of layers, may include at least a dielectric material. The dielectric material may include, for example, a single dielectric material or a combination or mixture of two or more dielectric materials, such as $SiO_2$, $Ta_2O_5$, $NbTaOs$, $Nb_2O_5$, $TiO_2$, $NbTiO_x$, $Al_2O_3$, $Si_3N_4$, $Cr_2O_3$, $MoOs$, and combinations thereof. In some implementations, the optical element 108 may include one or more dielectric material ("D") and metal material ("M") pairs of layers ("DM" pairs of layers), such as arranged in a particular stack order. In some implementations, each layer of the plurality of layers may be a thin film layer, and, accordingly, the optical element 108 may be an optical thin film (e.g., that has a thickness on the order of nanometers to micrometers).

As shown in Fig. 1B, the at least one aperture 114 is formed in the optical element 108. An aperture 114, of the at least one aperture 114 may be, for example, a region of the light emission surface 106 of the emitter 102 on which the optical element 108 is not disposed. That is, the aperture 114 may be a region of the light emission surface 106 of the emitter 102 that is not covered by the optical element 108. In some implementations, an aperture 114 may have, from a top-down view of the aperture 114, a round shape (e.g., a circular shape, an oval shape, and/or another round shape), such as the round shape shown in Fig. 1B. Alternatively, the aperture 114 may have a polygonal shape, such as a triangular shape, a rectangular shape, a pentagonal shape, a hexagonal shape, or another polygonal shape. While Fig. 1B shows a single aperture 114 formed in the optical element 108, more than one aperture 114 may be formed in the optical element 108 (e.g., associated with respective regions of the light emission surface 106 of the emitter 102).

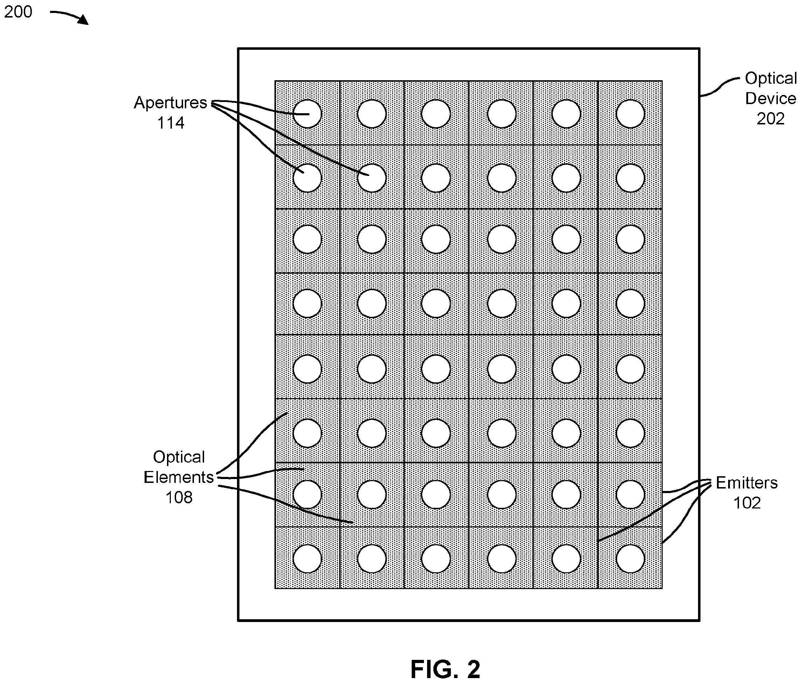

Fig. 2 is a diagram of an example implementation 200 associated with an optical element of an emitter. As shown in Fig. 2, the example implementation 200 includes an optical device 202. Fig. 2 shows an example top-down view of the optical device 202.

As shown in Fig. 2, the optical device 202 may include a plurality of emitters 102 (e.g., that are each the same as, or similar to, the emitter 102 described herein in relation to Figs. 1A-1B). For example, each emitter 102, of the plurality of emitters, may include a light emission region 104, a light emission surface 106, an optical element 108 with a first surface 110 and a second surface 112, and/or at least one aperture 114 formed in the optical element 108, as described herein in relation to Figs. 1A-1B.

The plurality of emitters 102 may be arranged in a pattern (e.g., a one-dimensional array, a two-dimensional array, or another type of pattern) within the optical device 202. For example, as shown in Fig. 2, the plurality of emitters 102 may be arranged in an 8×6 array. In some implementations, the plurality of emitters 102 may be arranged to form a display screen of the optical device 202 (e.g., where each emitter 102 acts as a pixel of the display screen, such as when each emitter 102 is a microLED).

In some implementations, a first set of emitters of the plurality of emitters 102 may each be configured to emit light associated with a first optical spectrum (e.g., red light) and therefore the first surface 110 of each optical element 108 of the first set of emitters may be configured to reflect light associated with the first optical spectrum; a second set of emitters of the plurality of emitters 102 may each be configured to emit light associated with a second optical spectrum (e.g., blue light) and therefore the first surface 110 of each optical element 108 of the second set of emitters may be configured to reflect light associated with the second optical spectrum; and/or a third set of emitters of the plurality of emitters 102 may each be configured to emit light associated with a third optical spectrum (e.g., green light) and therefore the first surface 110 of each optical element 108 of the third set of emitters may be configured to reflect light associated with the third optical spectrum; among other examples. Additionally, the second surface 112 of each optical element 108 of the first set of emitters, the second set of emitters, and the third set of emitters may be configured to absorb light associated with another optical spectrum (e.g., visible light) that includes at least the first optical spectrum, the second optical spectrum, and the third optical spectrum. In this way, the plurality of emitters 102 may appear (e.g., to a human observer or to a device configured to sense visible light) to have a same appearance (e.g., appear to have no reflection for red light, blue light, and green light). When the plurality of emitters 102 are included in a display screen of the optical device 202, the display screen may appear to be black (e.g., when the plurality of emitters 102 are not operating and emitting light).

As indicated above, Fig. 2 is provided as an example. Other examples may differ from what is described with regard to Fig. 2.

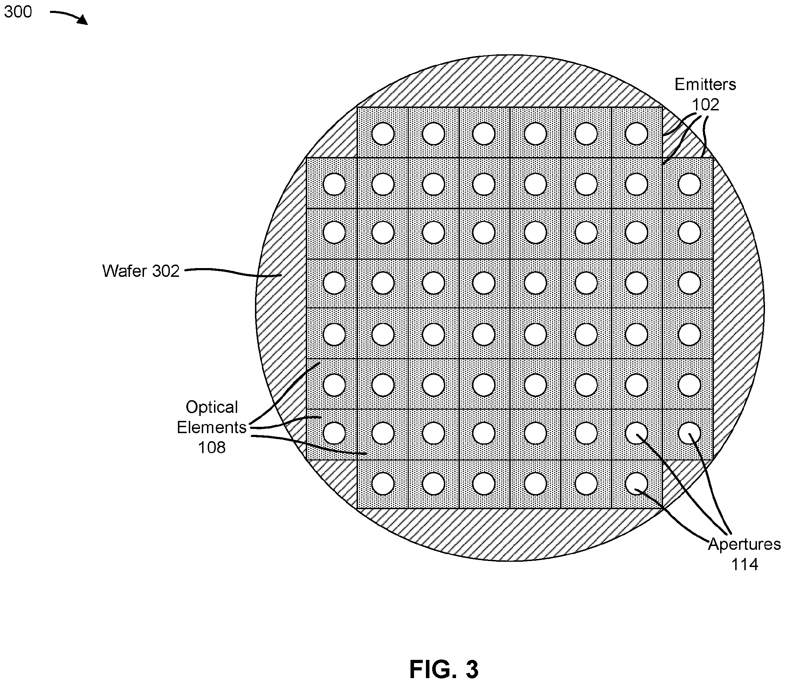

Fig. 3 is a diagram of an example implementation 300 associated with an optical element of an emitter. As shown in Fig. 3, the example implementation 300 includes a wafer 302. Fig. 3 shows an example top-down view of the wafer 302.

As shown in Fig. 3, the wafer 302 may include a plurality of emitters 102 (e.g., that are each the same as, or similar to, the emitter 102 described herein in relation to Figs. 1A-1B). For example, each emitter 102, of the plurality of emitters 102, may include a light emission region 104, a light emission surface 106, an optical element 108 with a first surface 110 and a second surface 112, and/or at least one aperture 114 formed in the optical element 108, as described herein in relation to Figs. 1A-1B. The plurality of emitters 102 may be formed on the wafer 302 using a sputtering procedure, a photolithographic procedure, an etching procedure, a lift off procedure, a scraping procedure, an annealing procedure, a molding procedure, a casting procedure, a machining procedure, a stamping procedure, and/or a singulation procedure, among other examples.

As further shown in Fig. 3, the plurality of emitters 102 may be disposed on (or a part of) the wafer 302 to utilize an optimal amount of a surface area of the wafer 302. Accordingly, a particular number of emitters 102 may be formed on the wafer 302, such as to optimally utilize the surface area of the wafer 302. The particular number may be greater than or equal to $\frac{2\pi R}{w}$, where R is a radius of the wafer 302 and w is a width (e.g., an x-dimension or a y-dimension of each emitter 102).

As indicated above, Fig. 3 is provided as an example. Other examples may differ from what is described with regard to Fig. 3.

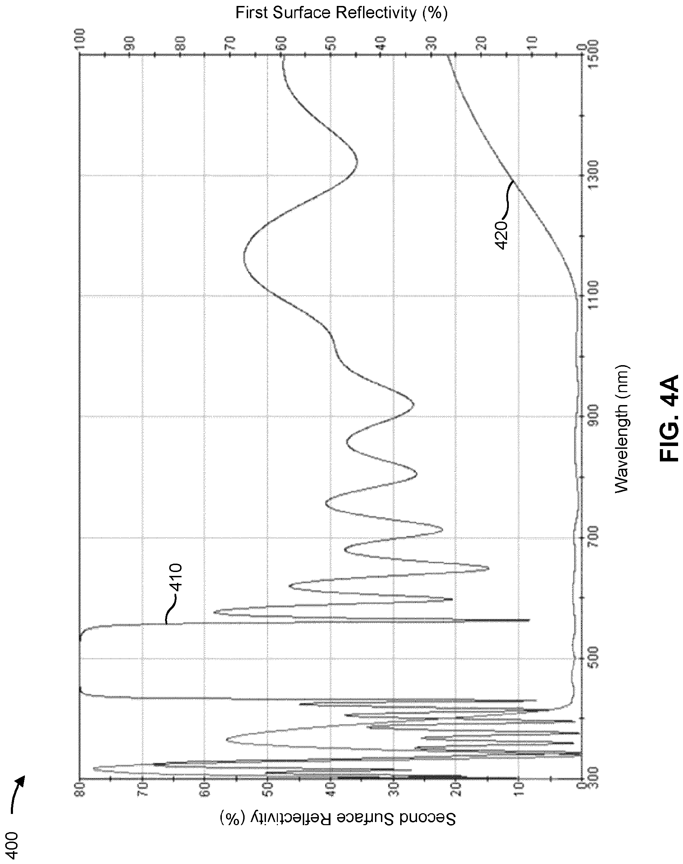

Figs. 4A-4D are diagrams of example plots 400 associated with an optical element of an emitter. The example plots 400 show, for different configurations of the emitter 102 described herein in relation to Figs. 1A-1B, respective reflectivities of the first surface 110 and the second surface 112 of the optical element 108 of the emitter 102.

Fig. 4A includes a curve 410 that shows a reflectivity of the first surface 110 of the optical element 108 when the first surface 110 is configured to reflect light associated with a first optical spectrum that includes blue light, and a curve 420 that shows a reflectivity of the second surface 112 of the optical element 108 when the second surface 112 is configured to reflect light associated with a second optical spectrum that includes visible light and a portion of near-infrared light.

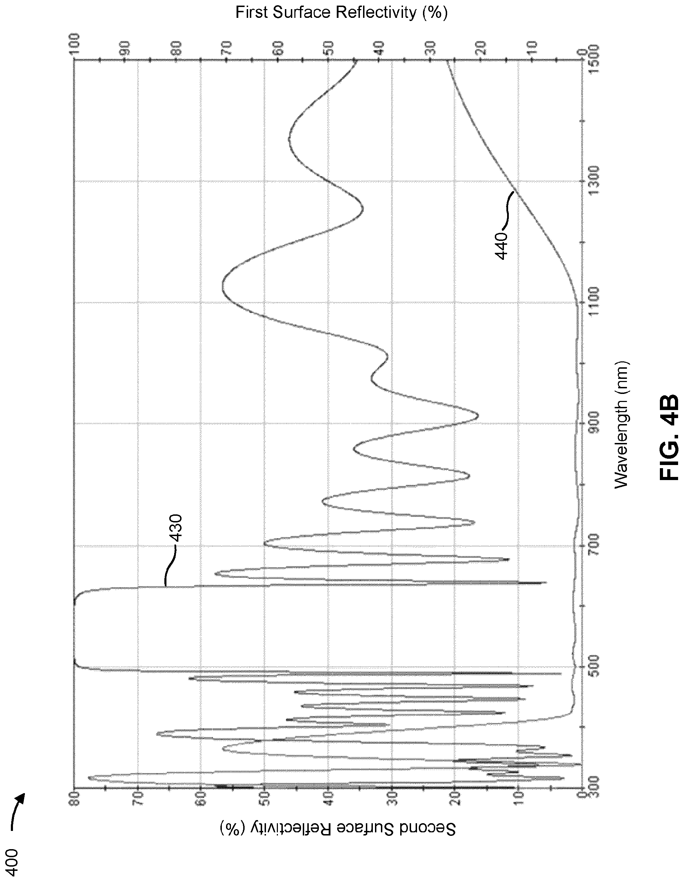

Fig. 4B includes a curve 430 that shows a reflectivity of the first surface 110 of the optical element 108 when the first surface 110 is configured to reflect light associated with a first optical spectrum that includes green light, and a curve 440 that shows a reflectivity of the second surface 112 of the optical element 108 when the second surface 112 is configured to reflect light associated with a second optical spectrum that includes visible light and a portion of near-infrared light.

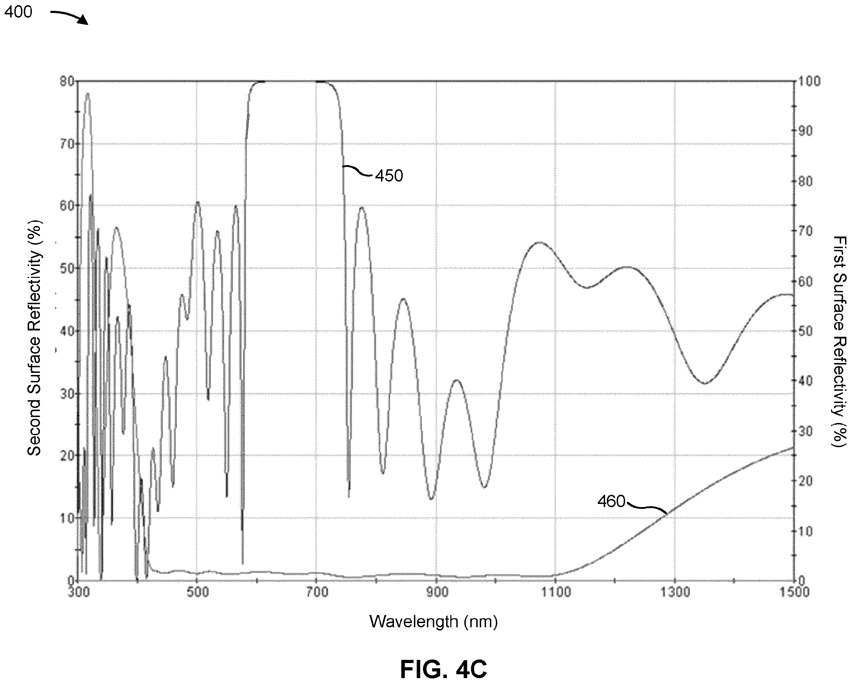

Fig. 4C includes a curve 450 that shows a reflectivity of the first surface 110 of the optical element 108 when the first surface 110 is configured to reflect light associated with a first optical spectrum that includes red light, and a curve 460 that shows a reflectivity of the second surface 112 of the optical element 108 when the second surface 112 is configured to reflect light associated with a second optical spectrum that includes visible light and a portion of near-infrared light.

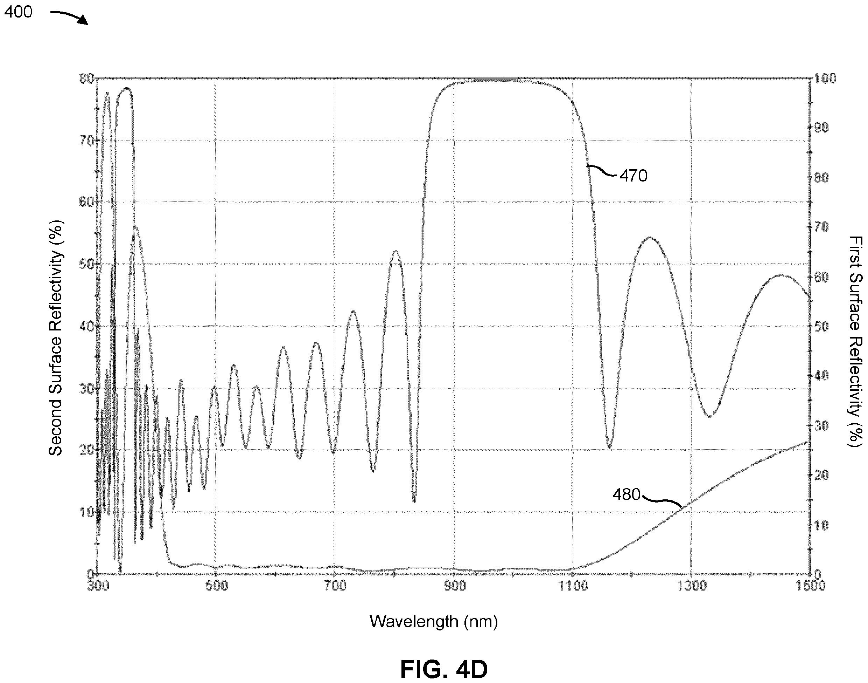

Fig. 4D includes a curve 470 that shows a reflectivity of the first surface 110 of the optical element 108 when the first surface 110 is configured to reflect light associated with a first optical spectrum that includes a portion of near-infrared light, and a curve 480 that shows a reflectivity of the second surface 112 of the optical element 108 when the second surface 112 is configured to reflect light associated with a second optical spectrum that includes visible light and the portion of near-infrared light.

As indicated above, Figs. 4A-4D are provided as an example. Other examples may differ from what is described with regard to Figs. 4A-4D.

The foregoing disclosure provides illustration and description, but is not intended to be exhaustive or to limit the implementations to the precise forms disclosed. Modifications and variations may be made in light of the above disclosure or may be acquired from practice of the implementations.

As used herein, satisfying a threshold may, depending on the context, refer to a value being greater than the threshold, greater than or equal to the threshold, less than the threshold, less than or equal to the threshold, equal to the threshold, not equal to the threshold, or the like.

Even though particular combinations of features are recited in the claims and/or disclosed in the specification, these combinations are not intended to limit the disclosure of various implementations. In fact, many of these features may be combined in ways not specifically recited in the claims and/or disclosed in the specification. Although each dependent claim listed below may directly depend on only one claim, the disclosure of various implementations includes each dependent claim in combination with every other claim in the claim set. As used herein, a phrase referring to "at least one of' a list of items refers to any combination of those items, including single members. As an example, "at least one of: a, b, or c" is intended to cover a, b, c, a-b, a-c, b-c, and a-b-c, as well as any combination with multiple of the same item.

No element, act, or instruction used herein should be construed as critical or essential unless explicitly described as such. Also, as used herein, the articles "a" and "an" are intended to include one or more items, and may be used interchangeably with "one or more." Further, as used herein, the article "the" is intended to include one or more items referenced in connection with the article "the" and may be used interchangeably with "the one or more." Furthermore, as used herein, the term "set" is intended to include one or more items (e.g., related items, unrelated items, or a combination of related and unrelated items), and may be used interchangeably with "one or more." Where only one item is intended, the phrase "only one" or similar language is used. Also, as used herein, the terms "has," "have," "having," or the like are intended to be open-ended terms. Further, the phrase "based on" is intended to mean "based, at least in part, on" unless explicitly stated otherwise. Also, as used herein, the term "or" is intended to be inclusive when used in a series and may be used interchangeably with "and/or," unless explicitly stated otherwise (e.g., if used in combination with "either" or "only one of'). Further, spatially relative terms, such as "below," "lower," "bottom," "above," "upper," "top," and the like, may be used herein for ease of description to describe one element or feature's relationship to another element(s) or feature(s) as illustrated in the figures. The spatially relative terms are intended to encompass different orientations of the apparatus, device, and/or element in use or operation in addition to the orientation depicted in the figures. The apparatus may be otherwise oriented (rotated 90 degrees or at other orientations) and the spatially relative descriptors used herein may likewise be interpreted accordingly.

As used herein, the term "X material," where X is a chemical composition indicates that at least a threshold percentage of X is included in the X material or X solution. The threshold percentage may be, for example, greater than or equal to 1%. 5%. 10%, 25%. 50%. 75%, 85%. 90%. 95%, and/or 99%. As used herein, when a material is referred to by a specific chemical name or formula, the material may include non-stoichiometric variations of the stoichiometrically exact formula identified by the chemical name or formula. Further, the material may include ternary, quaternary, and higher-order compounds.

**Claims**

1. An emitter (102), comprising:

   a light emission region (104) configured to emit light associated with a first optical spectrum;
   a light emission surface (106); and
   an optical element (108) disposed on the light emission surface, wherein:

      a first surface (110) of the optical element, which contacts the light emission surface, is configured to reflect light associated with the first optical spectrum,

a second surface (112) of the optical element, opposite the first surface of the optical element, is configured to absorb light associated with a second optical spectrum, and at least one aperture (114) is formed in the optical element.

2. The emitter of claim 1, wherein the optical element comprises a plurality of layers, wherein:

at least one layer, of the plurality of layers, includes at least a metal material; and at least one other layer, of the plurality of layers, includes at least a dielectric material.

3. The emitter of claim 1 or claim 2, wherein the second optical spectrum is at least partially co-extensive with the first optical spectrum.

4. The emitter of any one of the previous claims, wherein the first surface of the optical element is configured to reflect at least a threshold percentage of light associated with the first optical spectrum, wherein the threshold percentage is greater than or equal to at least one of: 50%, 75%, 85%, 90%, 95%, 99%, or 99.5%.

5. The emitter of any one of the preceding claims, wherein the second surface of the optical element is configured to absorb at least a threshold percentage of light associated with the second optical spectrum, wherein the threshold percentage greater than or equal to at least one of: 50%, 75%, 85%, 90%, 95%, 99%, or 99.5%.

6. The emitter of claim 4 or claim 5, wherein either the first surface of the optical element is configured to reflect at least the threshold percentage of light associated with the first optical spectrum when the light impinges on the first surface at an incidence angle that is less than an incidence angle threshold, or the second surface of the optical element is configured to absorb at least the threshold percentage of light associated with the second optical spectrum when the light impinges on the second surface at an incidence angle that is less than an incidence angle threshold,

and wherein the incidence angle threshold is less than or equal to at least one of:

5 degrees,
10 degrees,
15 degrees,
25 degrees,
35 degrees,

50 degrees,
60 degrees, or
75 degrees.

7. The emitter of any one of the preceding claims, wherein the first optical spectrum has a spectral width greater than or equal to at least one of: 25 nanometers (nm), 30 nm, 35 nm, or 40 nm.

8. The emitter of any one of the preceding claims, wherein the optical element is an optical thin film.

9. The emitter of any one of the preceding claims, wherein the at least one aperture has one of a round shape, or a polygonal shape.

10. The emitter of any one of the preceding claims, wherein the optical element has a maximum junction temperature within a temperature range from 85 degrees Celsius to 150 degrees Celsius.

11. An optical device (202) comprising a plurality of emitters and a plurality of optical elements respectively disposed on light emission surfaces of the plurality of emitters, or a wafer (302) comprising a plurality of emitters and a plurality of optical elements respectively disposed on the plurality of emitters, wherein for each optical element:

a first surface of the optical element, that is disposed on a light emission surface of an emitter or a light emission surface of an emitter, is configured to reflect light associated with a first optical spectrum;
a second surface of the optical element is configured to absorb light associated with a second optical spectrum; and
at least one aperture is formed in the optical element.

12. The optical device or wafer of claim 11, wherein each optical element comprises a plurality of layers, wherein:

at least one layer, of the plurality of layers, includes at least a metal material; and at least one other layer, of the plurality of layers, includes at least a dielectric material.

13. The optical device or wafer of claim 11 or claim 12, wherein the first optical spectrum has a spectral width greater than or equal to at least one of: 25 nanometers (nm), 30 nm, 35 nm, or 40 nm.

14. The optical device of any one of claims 11 to 13, wherein the second optical spectrum includes a wavelength range from 380 to 780 nanometers.

**15.** The wafer of any one of claims 11 to 13, wherein each emitter is configured to emit light associated with the first optical spectrum, or wherein each emitter is a light-emitting diode (LED), or both.

EP 4 475 199 A1

100

Emitter
102

Optical
Element
108

Aperture
114

Second
Surface
112

Light
Emission
Surface
106

First
Surface
110

Light Emission Region 104

**FIG. 1A**

**FIG. 1B**

EP 4 475 199 A1

**FIG. 2**

EP 4 475 199 A1

**FIG. 3**

EP 4 475 199 A1

**FIG. 4A**

FIG. 4B

EP 4 475 199 A1

First Surface Reflectivity (%)

450

460

Second Surface Reflectivity (%)

Wavelength (nm)

**FIG. 4C**

400

**FIG. 4D**

Europäisches
Patentamt

European
Patent Office

Office européen
des brevets

# EUROPEAN SEARCH REPORT

Application Number

EP 24 18 0080

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2007/085471 A1 (COK RONALD S [US]) 19 April 2007 (2007-04-19) * paragraph [0027] - paragraph [0036]; figures 1-5 * | 1-10 | INV. H01L33/44 H01L33/46 |
| X | GB 2 443 220 A (TOSHIBA RES EUROP LTD [GB]) 30 April 2008 (2008-04-30) * page 9 - page 10; figures 3, 4 * * page 17; figure 10 * | 1-10 | |
| X | US 2021/384388 A1 (CHA NAMGOO [KR] ET AL) 9 December 2021 (2021-12-09) * paragraph [0127] - paragraph [0160]; figures 4-7 * | 1-15 | |
| X | GB 2 601 495 A (PLESSEY SEMICONDUCTORS LTD [GB]) 8 June 2022 (2022-06-08) * figures 1-15 * & US 2024/021656 A1 (MEZOUARI SAMIR [GB] ET AL) 18 January 2024 (2024-01-18) * paragraph [0039] - paragraph [0062]; figures 1-15 * | 1-15 | TECHNICAL FIELDS SEARCHED (IPC) H01L |

The present search report has been drawn up for all claims

| Place of search | Date of completion of the search | Examiner |
|---|---|---|
| The Hague | 28 October 2024 | Franssen, Gijs |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 24 18 0080

This annex lists the patent family members relating to the patent documents cited in the above-mentioned European search report.
The members are as contained in the European Patent Office EDP file on
The European Patent Office is in no way liable for these particulars which are merely given for the purpose of information.

28-10-2024

| Patent document cited in search report | | Publication date | Patent family member(s) | | Publication date |
|---|---|---|---|---|---|
| US 2007085471 | A1 | 19-04-2007 | US 2007085471 A1 | | 19-04-2007 |
| | | | WO 2007047601 A1 | | 26-04-2007 |
| GB 2443220 | A | 30-04-2008 | NONE | | |
| US 2021384388 | A1 | 09-12-2021 | NONE | | |
| GB 2601495 | A | 08-06-2022 | CN 116529897 A | | 01-08-2023 |
| | | | EP 4256609 A1 | | 11-10-2023 |
| | | | GB 2601495 A | | 08-06-2022 |
| | | | JP 2023553851 A | | 26-12-2023 |
| | | | KR 20230113558 A | | 31-07-2023 |
| | | | TW 202236591 A | | 16-09-2022 |
| | | | US 2024021656 A1 | | 18-01-2024 |
| | | | WO 2022117995 A1 | | 09-06-2022 |

EPO FORM P0459

For more details about this annex : see Official Journal of the European Patent Office, No. 12/82

**EP 4 475 199 A1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 63506567